# EUROPEAN PATENT SPECIFICATION

(11) **EP 2 988 477 B1**
(45) Date of publication and mention of the grant of the patent: **20.09.2017**
(21) Application number: 13882275.4
(22) Date of filing: 25.10.2013
(51) Int. Cl.: H04M 1/02, G06K 7/00

(54) **CARD RECEIVER AND MOBILE TERMINAL**
DATENKARTENAUFNAHME UND MOBILES ENDGERÄT
RÉCEPTEUR DE CARTES ET TERMINAL MOBILE

(30) Priority: 16.04.2013 CN 201310130952
(43) Date of publication of application: 24.02.2016
(73) Proprietor: Xiaomi Inc., Beijing 100085 (CN)
(72) Inventor: WU, Fenghui, Beijing 100085 (CN); YAN, Kesheng, Beijing 100085 (CN); SHI, Shasha, Beijing 100085 (CN); WANG, Shaojie, Beijing 100085 (CN)
(74) Representative: Reeve, Nicholas Edward
(86) International application number: PCT/CN2013/085925
(87) International publication number: WO 2014/169608

(56) References cited:
- CN-A- 102 340 568
- CN-A- 102 665 302
- CN-A- 103 237 098
- CN-U- 202 014 243
- US-A1- 2006 110 958

## Description

### TECHNICAL FIELD

The disclosure relates to a technical field of communication equipment, and more particularly, relates to a card holder and a mobile terminal.

### BACKGROUND

With the improvement of science and technology, the developments of various mobile terminals (such as mobile phones, notebooks, tablet PCs and so on) are changing with each passing day. The structure, style and performance, etc. of the mobile phone, for example, are updated more frequently.

Generally, a card holder, which is matched with a mobile phone card, is provided in a mobile phone, and can only match with the mobile phone cards with the same size. The technical disadvantage lies in, when a user needs to use a mobile phone card with another size, since the card holder is unable to match with such card, the mobile phone will be unavailable, the matching between the card holder and the card is poor, and it is inconvenient to use. Document US2006/0110958 discloses a card holder, comprising: a card holder body, including a support plane for supporting a card for a mobile terminal; a plurality of inlaid pieces each of which is pivotally mounted on the card holder body.

### SUMMARY OF THE INVENTION

The invention provides a card holder and a mobile terminal to improve the matching between the card holder and the card, and increase the convenience when a user uses the mobile terminal.

According to one aspect of the invention, there is provided a card holder, including:
a card holder body, including a support plane for supporting a card for a mobile terminal;
a plurality of inlaid pieces, each of which is pivotally mounted on the card holder body, and is able to rotate to a first position perpendicular to the support plane and rotate to a second position not extending from the support plane;
wherein the card for a mobile terminal is fixable among inlaid pieces which have been rotated to the first position.

Preferably, the card holder body includes a block wall on the periphery of the support plane.

Preferably, each inlaid piece includes a stepped snap portion, and the card for the mobile terminal is snapped fixedly among several inlaid pieces which have been rotated to the first position.

Preferably, the card holder body includes:
an inlaid piece fixing plate, provided with a fixing seat for each inlaid piece respectively, the inlaid piece being pivotally mounted on a corresponding fixing seat by a pin shaft; and
a support plate, fixed on the inlaid piece fixing plate, provided with a hole for each inlaid piece respectively, extended out of the hole when the inlaid piece is rotated to the first position, and located in the hole when the inlaid piece is rotated to the second position.

More preferably, the inlaid piece fixing plate includes at least a pair of first lock hooks opposite to each other. For each pair of first lock hooks, the support plate includes a pair of second lock hooks which are meshed with the pair of first lock hooks.

Alternatively, the types of the card for the mobile terminal include Mini SIM card, Micro SIM card and Nano SIM card.

According to another aspect of the invention, there is provided a mobile terminal including the card holder according to any one of the technical solutions mentioned above.

The invention may bring one or more of the following advantageous effects.

In a solution of the invention, a plurality of inlaid pieces is pivotally mounted on the card holder body respectively, such that several inlaid pieces in corresponding locations may be rotated to the first position perpendicular to the support plane and the rest of the inlaid pieces may be rotated to the second position not higher than the support plane, according to the type of the card for the mobile terminal, and then the card for the mobile terminal may be snapped fixedly among several inlaid pieces. The card holder of this solution may also apply to cards with different sizes, and match with the card better, and greatly improve convenience when the mobile terminal is used.

### BRIEF DESCRIPTION OF THE DRAWINGS

Fig. 1a is a schematic diagram of a card holder and a Micro SIM card after assembly according to an embodiment of the disclosure;
Fig. 1b is a schematic diagram of a card holder and a Micro SIM card before assembly according to an embodiment of the disclosure;
Fig. 2a is a schematic diagram of a card holder and a Mini SIM card after assembly according to an embodiment of the disclosure;
Fig. 2b is a schematic diagram of a card holder and a Mini SIM card before assembly according to an embodiment of the disclosure;
Fig. 3a is a schematic diagram of a card holder and a Nano SIM card after assembly according to an embodiment of the disclosure;
Fig. 3b is a schematic diagram of a card holder and a Nano SIM card before assembly according to an embodiment of the disclosure;
Fig. 4 is a exploded structure diagram of the card holder according to an embodiment of the disclosure;
Fig. 5a is an illustrative schematic diagram of the inlaid piece at the first position;
Fig. 5b is an illustrative schematic diagram of the inlaid piece at the second position;
Fig. 6a is an illustrative schematic diagram of the fixed form of the inlaid piece fixing plate and the support plate; and
Fig. 6b is a partial enlarged diagram of portion A in Fig. 6a.

### Reference signs used in the drawings:

- 11 -: card holder body
- 12 -: support plane
- 13 -: inlaid piece
- 14 -: card
- 15 -: block wall
- 16 -: snap portion
- 17 -: inlaid piece fixing plate
- 18 -: fixing seat
- 19 -: pin shaft
- 20 -: support plate
- 21 -: hole
- 22 -: first lock hook
- 23 -: second lock hook

### DETAILED DESCRIPTION

In order to improve the matching between a card holder and a card, and increase convenience when a mobile terminal is used, an embodiment of the disclosure provides a card holder and a mobile terminal. In this solution, a plurality of inlaid pieces is pivotally mounted on a card holder body respectively. According to the type of the card for the mobile terminal, several inlaid pieces in the corresponding locations may be rotated to the first position perpendicular to the support plane, and the rest of the inlaid pieces may be rotated to the second position not higher than the support plane. In this way, the card for the mobile terminal can be snapped fixedly among the several inlaid pieces. The card holder of this solution is adaptable to the cards with different sizes and thereby better matches the card. Thus, convenience will be greatly increased when the mobile terminal is used. Hereinafter, reference will be made in detail to the embodiments of the present disclosure.

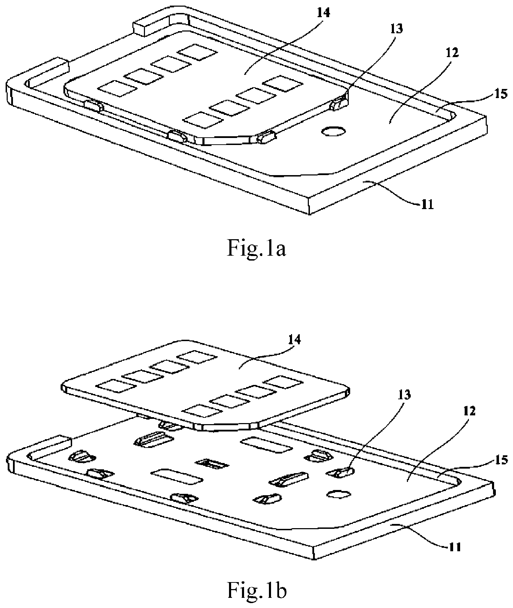

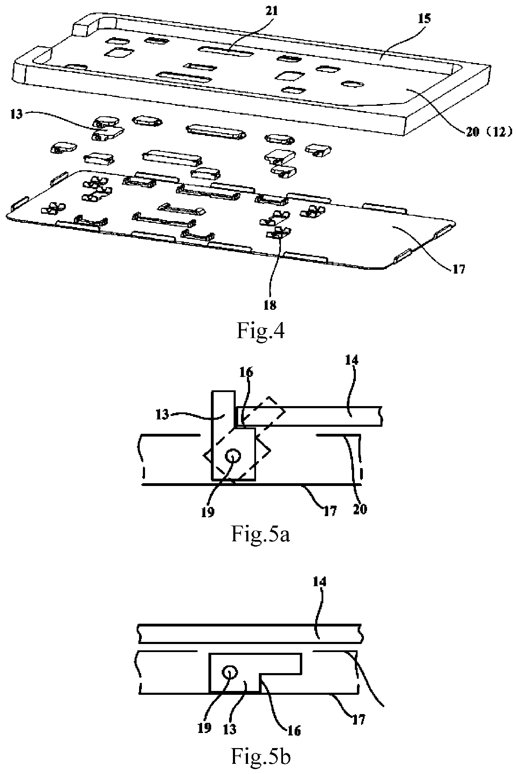

As shown in Fig. 1a, Fig. 1b and Fig. 4, a card holder according to an embodiment of the disclosure includes:
a card holder body 11, including a support plane 12 for supporting the card;
a plurality of inlaid pieces 13, each of which is pivotally mounted on the card holder body 11, and may be rotated to a first position perpendicular to the support plane 12 and may be rotated to a second position not higher than the support plane 12; and
a card 14 for a mobile terminal, snapped fixedly among several inlaid pieces 13 which have been rotated to the first position.

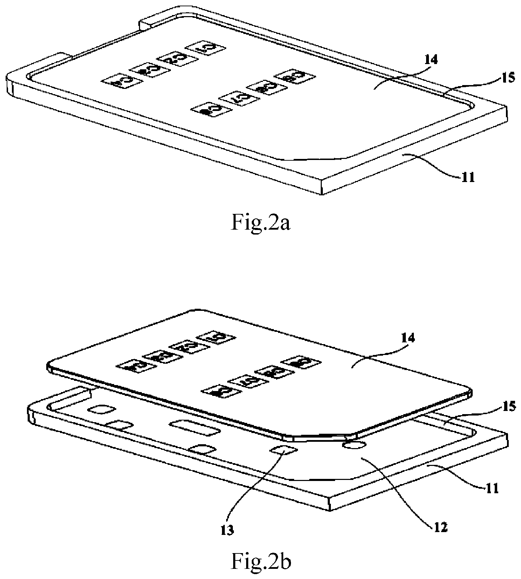

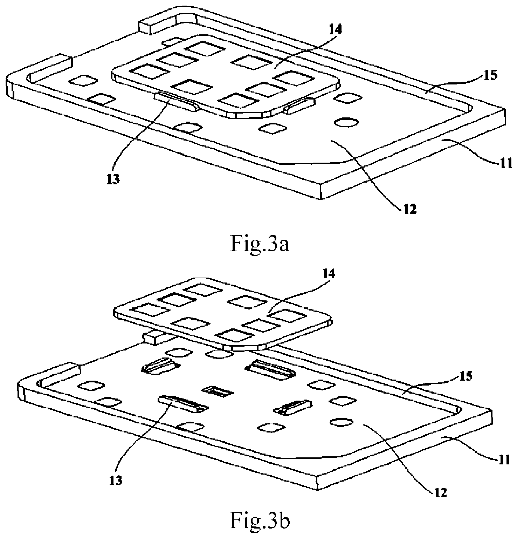

There is no limitation to the type of the mobile terminal of the disclosure, and the mobile terminal may be a mobile phone, a notebook or a tablet PC. There is also no limitation to the type of the card 14 for matching with the card holder. For example, the card may be a Mini SIM card (see Fig. 2a and Fig. 2b), a Micro SIM card (see Fig. 1a and Fig. 1b), a Nano SIM card (see Fig. 3a and Fig. 3b), and so on.

There is no limitation to the number of the inlaid pieces 13, so long as the positions of the various types of cards 14 can be restricted respectively. In an embodiment shown in Fig. 4, twelve inlaid pieces 13 are provided in total. As shown in Fig. 1a and Fig. 1b, when a user needs to use a Micro SIM card, eight inlaid pieces 13 at preset locations can be rotated to the first position, and the rest of the inlaid pieces 13 can be at the second position. In the similar way, as seen in Fig. 3a and Fig. 3b, when a user needs to use a Nano SIM card, four inlaid pieces 13 at preset locations can be rotated to the first position, so as to restrict the position of the Nano SIM card.

In an embodiment of the disclosure, a plurality of inlaid pieces 13 is pivotally mounted on the card holder body 11 respectively. According to the type of the card 14 for the mobile terminal, several inlaid pieces 13 in the corresponding locations are rotated to the first position perpendicular to the support plane 12, and the rest of the inlaid pieces 13 are rotated to the second position not higher than the support plane 12. In this way, the card 14 for the mobile terminal may be snapped fixedly among several inlaid pieces 13. The card holder of this solution may adapt to various cards 14 with different sizes, improve the matching between the card holder and the card 14, and greatly increase convenience when the mobile terminal is used.

Referring to Fig. 2a and Fig. 2b, the card holder body 11 includes a block wall 15 at the periphery of the support plane 12. The block wall 15 may also restrict the position of a card with a certain size (for example, a Mini SIM card), and increase the types of the cards which can match with the card holder, and further improve convenience when the mobile terminal is used.

There is no limitation to the shape of the inlaid piece 13, as seen in Fig. 5a and Fig. 5b. In an embodiment, each inlaid piece 13 includes a stepped snap portion 16. The card 14 for the mobile terminal is snapped fixedly among the snap portions 16 of several inlaid pieces 13 which have been rotated to the first position, such that the fixation is more secure. In addition, the card 14 for the mobile terminal may be also directly snapped fixedly in a receiving space formed by the several inlaid pieces 13 and the support plane 12.

The card holder body 11 may be an integrated structure or an assembled structure. As seen in Fig. 4, in an embodiment, the card holder body 11 includes:
an inlaid piece fixing plate 17, provided with a fixing seat 18 for each inlaid piece 13 respectively, the inlaid pieces 13 being pivotally mounted on a corresponding fixing seat 18 with a pin shaft 19; and
a support plate 20, fixed on the inlaid piece fixing plate 17, provided with a hole 21 for each inlaid piece 13 respectively, extended out of the hole 21 when the inlaid piece 13 is rotated to the first position, and located in the hole 21 when the inlaid piece 13 is rotated to the second position.

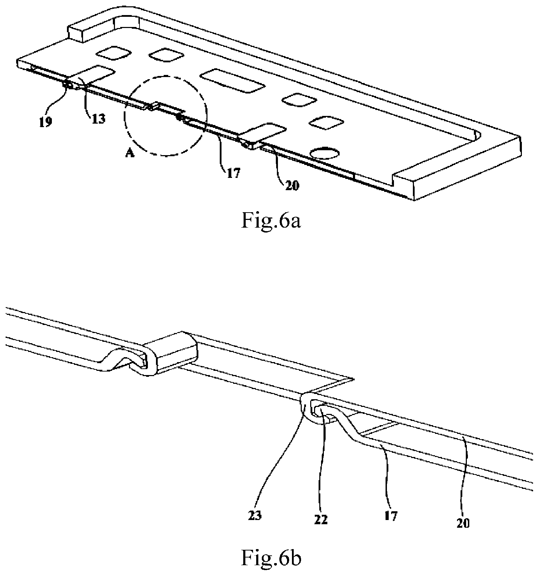

A gap may be provided between the inlaid piece fixing plate 17 and the support plate 20 (as shown in Fig. 6), or a non-gap design may be taken, as long as the inlaid piece 13 can be rotated to the first position, extended out of the hole 21, rotated to the second position, and located in the hole 21, that is, the inlaid piece 13 is no higher than the support plane 12.

The inlaid piece fixing plate 17 and the support plate 20, for example, are thin plates, and the card holder has a smaller thickness in total. There is no limitation to the fixed form between the inlaid piece fixing plate 17 and the support plate 20, For example, as seen from Fig. 6a and Fig. 6b, the inlaid piece fixing plate 17 includes at least a pair of first lock hooks 22 opposite to each other; for each pair of first lock hooks 22, the support plate 20 includes a pair of second lock hooks 23 for meshing with the pair of first lock hooks 22.

A pair of first lock hooks 22 are provided opposite to each other (the second lock hooks are similar). The pair of first lock hooks may be arranged face to face with each other or arranged offset with each other, however, the directions of the hooks should be arranged in an opposite way, as long as the two plates can be fixed. The two plates are fixed together by a snap self-locking structure, which makes the assembly convenient, the weight lighter, and the fixation of the two plates stable and reliable, and also the whole depth of the card holder will not be increased. Therefore, the design of the product is greatly optimized.

The disclosure also provides a mobile terminal including said card holder in any embodiment aforementioned. The mobile terminal may be matched with various types of cards, and be used conveniently.

It is apparent that various variations and modifications can be made for the disclosure by those skilled in the art without departing from the scope of the disclosure. Therefore, the disclosure intends to include these variations and modifications provided these variations and modifications of the disclosure belong to the claims.

## Claims

1. A card holder, **characterized in that** the card holder comprises:
a card holder body (11), including a support plane (12) for supporting a card for a mobile terminal (14);
a plurality of inlaid pieces (13), each of which is pivotally mounted on the card holder body (11), **characterized in that** each of said inlaid pieces is able to be rotated to a first position perpendicular to the support plane (12) and be rotated to a second position not extending from the support plane (12);
wherein the card (14) for a mobile terminal is fixable among inlaid pieces (13) which have been rotated to the first position.

2. The card holder according to claim 1, **characterized in that** the card holder body (11) has a block wall (15) at the periphery of the support plane (12).

3. The card holder according to claim 1, **characterized in that** each inlaid piece (13) includes a stepped snap portion (16), and the card (14) for the mobile terminal is fixable among the snap portions (16) of the inlaid pieces (13) which have been rotated to the first position.

4. The card holder according to any one of claims 1 to 3, **characterized in that** the card holder body (11) comprises:
an inlaid piece fixing plate (17), provided with a fixing seat (18) for each inlaid piece (13) respectively, the inlaid piece (13) being pivotally mounted on a corresponding fixing seat (18) with a pin shaft (19);
a support plate (20), fixed at the inlaid piece fixing plate (17), provided with a hole (21) for each inlaid piece (13) respectively, each inlaid piece (13) being extended out of the hole (21) when the inlaid piece (13) has been rotated to the first position, and being located in the hole (21) when the inlaid piece (13) is rotated to the second position.

5. The card holder according to claim 4, **characterized in that** the inlaid piece fixing plate (17) includes at least a pair of first lock hooks (22) opposite to each other, and for each pair of first lock hooks (22) the support plate (20) includes a pair of second lock hooks (23) which are meshed with the pair of first lock hooks (22).

6. The card holder according to claim 1, **characterized in that** the types of cards for the mobile terminal comprise Mini SIM card, Micro SIM card and Nano SIM card.

7. A mobile terminal, **characterized in that** the mobile terminal comprises the card holder according to any one of claims 1 to 6.

## Patentansprüche

1. Kartenhalter, **dadurch gekennzeichnet, dass** der Kartenhalter Folgendes aufweist:
einen Kartenhalterkörper (11) mit einer Trägerebene (12) zum Tragen einer Karte für ein mobiles Endgerät (14);
mehrere Einlegestücke (13), die jeweils schwenkbar an dem Kartenhalterkörper (11) montiert sind, **dadurch gekennzeichnet, dass** jedes der genannten Einlegestücke auf eine erste Position, zur Trägerebene (12) lotrecht, gedreht werden kann und auf eine zweite Position, sich nicht aus der Trägerebene (12) heraus erstreckend, gedreht werden kann;
wobei die Karte (14) für ein mobiles Endgerät zwischen Einlegestücken (13), die auf die erste Position gedreht wurden, fixierbar ist.

2. Kartenhalter nach Anspruch 1, **dadurch gekennzeichnet, dass** der Kartenhalterkörper (11) am Umfang der Trägerebene (12) eine Blockwand (15) hat.

3. Kartenhalter nach Anspruch 1, **dadurch gekennzeichnet, dass** jedes Einlegestück (13) einen abgestuften Einschnappteil (16) beinhaltet und die Karte (14) für das mobile Endgerät zwischen den Einschnappteilen (16) der Einlegestücke (13), die auf die erste Position gedreht wurden, fixierbar ist.

4. Kartenhalter nach einem der Ansprüche 1 bis 3, **dadurch gekennzeichnet, dass** der Kartenhalterkörper (11) Folgendes aufweist:
eine Einlegestückfixierplatte (17), die jeweils mit einem Fixiersitz (18) für jedes Einlegestück (13) versehen ist, wobei das Einlegestück (13) mit einer Stiftachse (19) schwenkbar an einem entsprechenden Fixiersitz (18) montiert ist;
eine Trägerplatte (20), an der Einlegestückfixierplatte (17) fixiert, die jeweils mit einem Loch (21) für jedes Einlegestück (13) versehen ist, wobei sich jedes Einlegestück (13) aus dem Loch (21) heraus erstreckt, wenn das Einlegestück (13) auf die erste Position gedreht worden ist, und in dem Loch (21) liegt, wenn das genannte Einlegestück (13) auf die zweite Stellung gedreht worden ist.

5. Kartenhalter nach Anspruch 4, **dadurch gekennzeichnet, dass** die genannte Einlegestückfixierplatte (17) wenigstens ein Paar erster Verriegelungshaken (22), die einander gegenüberliegen, beinhaltet und die Trägerplatte (20) für jedes Paar erster Verriegelungshaken (22) ein Paar zweiter Verriegelungshaken (23) beinhaltet, die mit dem Paar erster Verriegelungshaken (22) in Eingriff sind.

6. Kartenhalter nach Anspruch 1, **dadurch gekennzeichnet, dass** die Kartentypen für das mobile Endgerät Mini-SIM-Karte, Mikro-SIM-Karte und Nano-SIM-Karte umfassen.

7. Mobiles Endgerät, **dadurch gekennzeichnet, dass** das mobile Endgerät den Kartenhalter nach einem der Ansprüche 1 bis 6 aufweist.

## Revendications

1. Porte-carte, **caractérisé en ce que** le porte-carte comprend :
un corps de porte-carte (11), comprenant un plan de support (12) pour soutenir une carte pour un terminal mobile (14) :
une pluralité de pièces incrustées (13), chacune desquelles est montée d'une manière pivotante sur le corps du porte-carte (11), **caractérisé en ce que** chacune desdites pièces incrustées peut être tournée à une première position perpendiculaire au plan de support (12) et être tournée à une deuxième position ne s'étendant pas du plan de support (12);
dans lequel la carte (14) pour un terminal mobile peut être fixée entre les pièces incrustées (13) qui ont été tournées à la première position.

2. Porte-carte selon la revendication 1, **caractérisé en ce que** le corps du porte-carte (11) a une paroi de blocage (15) à la périphérie du plan de support (12).

3. Porte-carte selon la revendication 1, **caractérisé en ce que** chaque pièce incrustée (13) comprend une partie d'enclenchement en gradins (16) et la carte (14) pour le terminal mobile peut être fixée entre les parties d'enclenchement (16) des pièces incrustées (13) qui ont été tournées à la première position.

4. Porte-carte selon l'une quelconque des revendications 1 à 3, **caractérisé en ce que** le corps du porte-carte (11) comprend :
une plaque de fixation (17) de pièces incrustées, pourvue d'une embase de fixation (18) pour chaque pièce incrustée (13) respectivement, la pièce incrustée (13) étant montée d'une manière pivotante sur une embase de fixation correspondante (18) avec une tige de broche (19) ;
une plaque d'appui (20), fixée à la plaque de fixation (17) de pièces incrustées, pourvue d'un trou (21) pour chaque pièce incrustée (13) respectivement, chaque pièce incrustée (13) s'étendant hors du trou (21) lorsque la pièce incrustée (13) a été tournée à la première position, et étant située dans le trou (21) lorsque la pièce incrustée (13) est tournée à la deuxième position.

5. Porte-carte selon la revendication 4, **caractérisé en ce que** la plaque de fixation (17) de pièces incrustées comprend au moins une paire de premiers crochets de verrouillage (22) opposés l'un à l'autre, et pour chaque paire de premiers crochets de verrouillage (22) la plaque d'appui (20) comprend une paire de deuxièmes crochets de verrouillage (23) qui s'engrènent avec la paire de premiers crochets de verrouillage (22).

6. Porte-carte selon la revendication 1, **caractérisé en ce que** les types de cartes pour le terminal mobile comprennent une carte Mini SIM, une carte Micro SIM et une carte Nano SIM.

7. Terminal mobile, **caractérisé en ce que** le terminal mobile comprend le porte-carte selon l'une quelconque des revendications 1 à 6.
